# EUROPEAN PATENT APPLICATION

(11) **EP 0 541 160 A1**
(43) Date of publication of application: **12.05.1993**
(21) Application number: 92203325.3
(22) Date of filing: 29.10.1992
(51) Int. Cl.: H01L 21/311, H01L 21/90

(54) **Method of manufacturing a semiconductor device whereby contact windows are provided in an insulating layer comprising silicon nitride in two etching steps**

(30) Priority: 07.11.1991 EP 91202894
(71) Applicant: Philips Electronics N.V., 5621 BA Eindhoven (NL)
(72) Inventor: Zijlstra, Piebe Anne, c/o INT. OCTROOIBUREAU B.V., NL-5656 AA Eindhoven (NL); Beekman, Johannes F., c/o INT. OCTROOIBUREAU B.V., NL-5656 AA Eindhoven (NL)
(74) Representative: Rensen, Jan Geert

(57) **Abstract**

A method of manufacturing a semiconductor device whereby an insulating layer (3) comprising silicon nitride is deposited on a surface (1) of a slice of semiconductor material (2), in which layer contact windows (8) are then provided in that the layer is locally covered with a layer of photoresist (5) and subsequently uncovered portions thereof are removed in two etching steps which are each carried out in a plasma containing fluorine and generated in a reaction chamber (20,21), so that the insulating layer (3) is etched away isotropically over part of its thickness during the first etching step and then anisotropically over its remaining thickness during the second etching step. The two etching steps are carried out in plasmas generated in gases containing less than 10 vol.% oxygen. It is achieved by this that the contact holes (8) in the layer (3) comprising silicon nitride can be so etched that they are practically identical seen over the surface of the entire slice and also from slice to slice.

## Description

The invention relates to a method of manufacturing a semiconductor device whereby an insulating layer comprising silicon nitride is deposited on a surface of a slice of semiconductor material, in which layer contact windows are subsequently provided in that the layer is locally covered with a layer of photoresist and uncovered portions thereof are then removed in two etching steps which are each carried out in a plasma containing fluorine and generated in a reaction chamber, so that the insulating layer is etched away isotropically over part of its thickness during the first etching step and, after that, anisotropically over its remaining thickness during the second etching step.

The insulating layer comprising silicon nitride may be a layer of practically pure silicon nitride, but alternatively it may be, for example, a layer of silicon nitride containing up to approximately 25 at. % hydrogen and deposited from one and the same gas phase at 250-350° C by means of a PECVD process (plasma enhanced chemical vapour deposition), from a gas phase comprising silane and ammonia or nitrogen, or may even be a layer of silicon oxynitride.

After the contact windows have been provided, a pattern of conductors may be provided on the insulating layer, making contact with the surface of the semiconductor body through the contact windows. This pattern of conductors may then make contact with semiconductor zones in the semiconductor body adjoining the surface, but also with another patten of conductors present at the surface, made of, for example, aluminium, polycrystalline silicon, or a metal silicide.

Since the contact windows are provided in the insulating layer in two etching steps according to the said method, these windows have a bottom diameter which corresponds to that of openings in the photoresist layer, whereas they have a greater diameter at the top. As a result, filling of the contact holes with material of the pattern of conductors which is provided on the insulating layer is comparatively easy. In principle, the walls have a rounded profile at the top and a straight profile at the bottom. In practice, these profiles merge into one another, and the contact holes have walls which are oblique relative to the surface.

JP-A-1/94621 discloses a method of the kind mentioned in the opening paragraph whereby the two etching steps are carried out in a plasma generated in a gas mixture with CF₄ and O₂. The first step in a plasma generated in a gas mixture of CF₄ to which 30 to 50 vol.% O₂ is added, the second step in a plasma generated in a gas mixture to which less O₂ is added. The layer comprising silicon nitride is etched isotropically in the first plasma and anisotropically in the second plasma.

The known method is comparatively easy to implement because only the quantity of oxygen conducted to the reaction chamber need be changed during the implementation thereof. The known method has the disadvantage, however, that contact holes thus etched may exhibit major differences seen over the surface of a slice. They are often much larger at the edge of the slice than in the centre thereof, while also the walls run much more obliquely in the former location. The extent of these differences in addition differs from slice to slice. The etching process is found to take place in a very inhomogeneous and uncontrolled manner.

The invention has for its object to provide a method by which the contact holes in the layer comprising silicon nitride can be etched in such a manner that the contact holes seen over the surface of the slice and also among different slices are practically identical.

According to the invention, the method is for this purpose characterized in that the two etching steps are carried out in plasmas generated in gases containing less than 10 vol.% oxygen. The etching processes are then found to take place in such a way that the etched contact holes, seen over the slice, are of practically equal dimensions and shape, while the differences in dimensions and shape from slice to slice are also very small.

The invention is based on the recognition of the fact that the said inhomogeneities are caused by erosion of the layer of photoresist which is present on the layer comprising silicon nitride during etching. This erosion, which is mainly caused by oxygen present in some form or other in the plasma, has the result that the openings in the photoresist layer change during etching. Since the quantity of oxygen is not equally large in the plasma everywhere and at all times, these changes are also unequal seen over the slice and seen from slice to slice.

Preferably, the first etching step is carried out in a plasma generated in NF₃ at a gas pressure of 10 to 30 Pa. The plasma contains comparatively small and light ions. It is achieved by this that the layer comprising silicon nitride is hit by ions having a low kinetic energy, so that etching takes place isotropically. This is especially true if the plasma is generated with an energy density of 30 to 300 mW/cc during this.

Furthermore, if during the first etching step the plasma is generated between two flat plates arranged at a distance of 15 to 30 mm from one another, of which one plate is energized while the other one is earthed, the slice being placed on the energized plate, etching takes place very homogeneously over the surface of the slice.

Preferably, the second etching step is carried out in a plasma which is generated at a gas pressure of 100 to 250 Pa in a gas mixture with CF₄ to which less than 10 (for example, 3) vol. % O₂ is added. The layer comprising silicon nitride can be etched anisotropically in such a plasma. The plasma itself contains no nitrogen. The light emitted by the plasma can accordingly be used for ascertaining whether the layer comprising silicon nitride has been entirely removed from the surface inside the contact holes. As long as the layer inside the contact holes has not yet been entirely removed, the light contains spectral bands emitted by nitrogen atoms and molecules detached from the layer. This is no longer the case when the layer has been removed.

Etching takes place anisotropically if during the second etching step the plasma is generated between two flat plates which are arranged at a distance of 5 to 10 mm from one another, of which one plate is energized while the other one is earthed, the slice being placed on the energized plate. This is particularly true if the plasma is generated with an energy density of 500 to 3000 mW/cc during this.

The invention will be explained in more detail below, by way of example, with reference to a drawing, in which:
Figs. 1 to 4 diagrammatically and in cross-section show some stages of manufacture of a semiconductor device manufactured by the method according to the invention, and
Fig. 5 diagrammatically shows a device suitable for carrying out the method according to the invention.

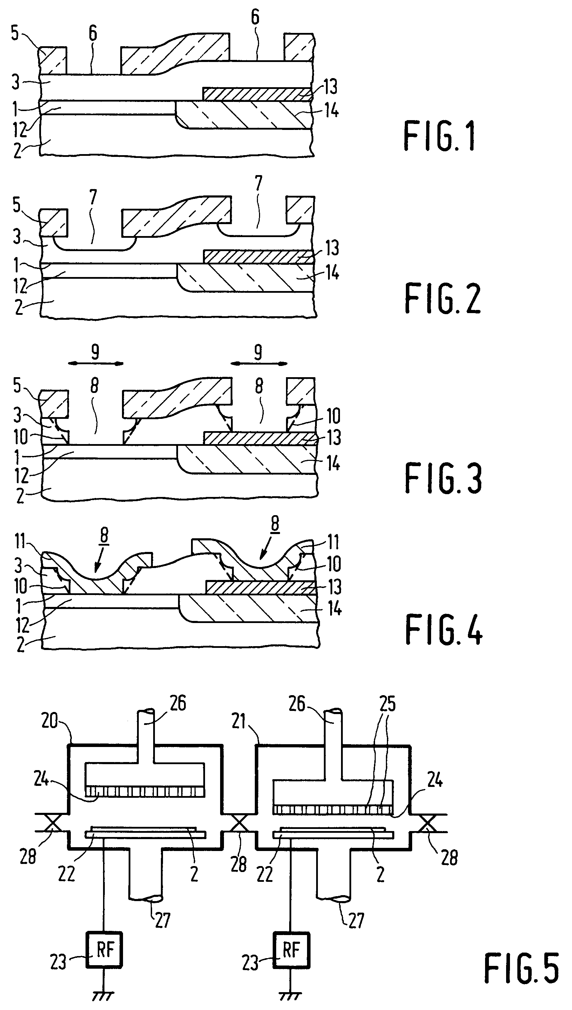

Figs. 1 to 4 diagrammatically and in cross-section show some stages in the manufacture of a semiconductor device whereby an approximately 1 µm thick insulating layer 3 comprising silicon nitride is deposited on a surface 1 of a slice of semiconductor material 2, which in the present example is a silicon slice having a diameter of approximately 150 cm and a thickness of approximately 500 µm. Contact windows 4 are subsequently provided in this layer 3 in that this layer is locally covered with a layer of photoresist 5, approximately 2 µm thick, upon which uncovered portions 6 of this layer 3 are removed in two etching steps. These steps are each carried out in a plasma containing fluorine, whereby the insulating layer 3 is etched away isotropically over part of its thickness during the first etching step and then anisotropically over its remaining thickness during the second etching step. A window 7 as shown in Fig. 2 is formed after the first etching step, and the contact window 8 as shown in Fig. 3 results after the second etching step.

Since the contact windows 8 are provided in the insulating layer 3 in the manner indicated in two etching steps, these windows 8 have a diameter 9 at the bottom which corresponds to that of openings in the photoresist layer 5, whereas they have a greater diameter at the top. In principle, the walls will have a rounded profile at the top and a straight profile at the bottom. In practice, these profiles merge into one another, and the contact holes 8 have walls as indicated with broken lines 10, extending obliquely relative to the surface.

After the photoresist layer 5 has been removed, a pattern of conductors 11 of, for example, aluminium is provided on the insulating layer 3. Since the walls 10 of the contact holes 8 are not perpendicular to the surface 1, filling of the contact holes 8 with material of the conductor pattern 11 which is provided on the insulating layer is comparatively easy. If the contact holes have perpendicular walls, the conductors 11 could show constricted portions at the then sharp transitions between the walls 10 of the contact windows 8 and the surface of the insulating layer 3.

The insulating layer 3 comprising silicon nitride may be a layer of practically pure silicon nitride, but it may alternatively be, for example, a layer of silicon nitride containing up to approximately 25 at % hydrogen and which is deposited from one and the same gas phase at 250 to 350° C by means of a PECVD process (plasma enhanced chemical vapour deposition), from a gas phase with silane and ammonia or nitrogen, or may even be a layer of silicon oxynitride.

The conductor pattern 11 may make contact with a semiconductor zone 12 adjoining the surface and provided in the semiconductor body 2, but also with another pattern of conductors 13 present at the surface 1 and made of, for example, aluminium, polycrystalline silicon, or a metal silicide. The pattern 13 lies, for example, on a layer of silicon oxide 14 provided in the semiconductor body.

The etching steps may be carried out, for example, in the device shown in Fig. 5. This device is provided with two reaction chambers 20 and 21. Each reaction chamber 20, 21 contains a flat plate 22 with a diameter of approximately 150 mm on which the slice 2 is arranged. This plate 22 is connected to a usual high-frequency voltage source 23. A second plate 24, which is earthed, is placed opposite the plate 22. When the voltage source 23 is switched on, a plasma is formed between the plates 22 and 24 in a gas which can be introduced into the space between the plates 22 and 24 through holes 25 in the plate 24. The gas is conducted into the chambers 20 and 21 through a line 26. The chambers are further connected *via* a line 27 to a pump (not shown) with which the gas and gaseous reaction products can be removed. A desired gas pressure can be realised in the chambers through control of the gas supply and discharge lines. The slice 2 may be introduced into the chamber 20 through air locks 28 (not described in any detail), transported from chamber 20 to chamber 21, and taken from chamber 21.

According to the invention, the two etching steps are carried out in plasmas generated in gases containing less than 10 vol.% oxygen. The etching processes are then found to take place in such a way that the etched contact holes 8, seen over the slice of which only a very small portion is shown in Figs. 1 to 4, are of practically equal dimensions and shape. The differences in dimensions and shape from slice to slice are also found to be very small.

Since the etching steps are carried out in plasmas generated in a gas containing only a very small quantity of oxygen, erosion of the photoresist layer 5 is avoided. This erosion may have the result that the diameter 9 of the openings in the photoresist layer 5 change during etching. Since the quantity of oxygen is not equally large in the plasma everywhere and at all times, these changes, seen over the slice and from slice to slice, may also be different.

Preferably, the first etching step is carried out in a plasma generated in NF₃ at a gas pressure of 10 to 30 Pa. The plasma contains comparatively small and light ions. It is achieved by this that the layer 3 comprising silicon nitride is hit by ions having a low kinetic energy. Etching is found to take place isotropically. This is particularly true if the plasma is generated with an energy density of 30 to 300 mW/cc during this.

The flat plates 22 and 24 are 15 to 30 mm interspaced from one another in the first chamber 20. It is achieved by this that etching takes place very homogeneously over the surface of the slice. The shape of the etched contact holes 8 is practically constant over the entire slice 2.

Preferably, the second etching step is carried out in a plasma generated at a gas pressure of 100 to 250 Pa in a gas mixture with CF₄ to which less than 10 vol. % O₂ is added. The layer 3 comprising silicon nitride can be etched anisotropically in such a plasma. The plasma itself contains no nitrogen. The light emitted by the plasma can accordingly be used for ascertaining whether the layer comprising silicon nitride inside the contact holes 8 has been entirely removed from the surface 1. As long as the layer inside the contact holes has not yet been entirely removed, the light contains spectral bands emitted by nitrogen atoms and molecules detached from the layer. This is no longer the case when the layer has been removed.

The plates 22 and 24 are spaced apart by 5 to 10 mm from one another in the second chamber 21. This achieves that etching takes place anisotropically. This is particularly true if the plasma is generated with an energy density of 500 to 3000 mW/cc during this.

## Claims

1. A method of manufacturing a semiconductor device whereby an insulating layer comprising silicon nitride is deposited on a surface of a slice of semiconductor material, in which layer contact windows are subsequently provided in that the layer is locally covered with a layer of photoresist and uncovered portions thereof are then removed in two etching steps which are each carried out in a plasma containing fluorine and generated in a reaction chamber, so that the insulating layer is etched away isotropically over part of its thickness during the first etching step and, after that, anisotropically over its remaining thickness during the second etching step, characterized in that the two etching steps are carried out in plasmas generated in gases containing less than 10 vol.% oxygen.

2. A method as claimed in Claim 1, characterized in that the first etching step is carried out in a plasma generated in NF₃ at a gas pressure of 10 to 30 Pa.

3. A method as claimed in Claim 2, characterized in that the second etching step is carried out in a plasma which is generated at a gas pressure of 100 to 250 Pa in a gas mixture with CF₄ to which less than 10 vol.% O₂ is added.

4. A method as claimed in Claim 2, characterized in that during the first etching step the plasma is generated between two flat plates arranged at a distance of 15 to 30 mm from one another, of which one plate is energized while the other one is earthed, the slice being placed on the energized plate.

5. A method as claimed in Claim 4, characterized in that the plasma is generated with an energy density of 30 to 300 mW/cc during the first etching step.

6. A method as claimed in Claim 3, characterized in that during the second etching step the plasma is generated between two flat plates which are arranged at a distance of 5 to 10 mm from one another, of which one plate is energized while the other one is earthed, the slice being placed on the energized plate.

7. A method as claimed in Claim 6, characterized in that the plasma is generated with an energy density of 500 to 2000 mW/cc during the second etching step.
